Europäisches Patentamt

European Patent Office

Office européen des brevets

(19)

(11) Numéro de publication: **0 085 622**
**B1**

(12)                    **FASCICULE DE BREVET EUROPEEN**

(45) Date de publication du fascicule du brevet:
11.09.85

(51) Int. Cl.⁴: **H 01 L 23/36**, H 01 L 23/52

(21) Numéro de dépôt: 83400198.4

(22) Date de dépôt: 28.01.83

(54) Support de montage de boîtier de circuit intégré, à connexions de sorties réparties sur le périmètre du boîtier.

(30) Priorité: 02.02.82 FR 8201652

(43) Date de publication de la demande:
10.08.83 Bulletin 83/32

(45) Mention de la délivrance du brevet:
11.09.85 Bulletin 85/37

(84) Etats contractants désignés:
DE GB IT NL

(56) Documents cités:
US - A - 3 753 056
US - A - 3 936 866

IEEE TRANSACTIONS ON MICROWAVE THEORY &
TECHNIQUES, vol. MTT-29, no. 4, avril 1981, pages
304,309, New York, USA Y. MITSUI et al.: "10-ghz 10-W
internally matched flip-chip GaAs power FET's"
IEEE TRANSACTIONS ON COMPONENTS, HYBRIDS &
MANUFACTURING TECHNOLOGY, vol. CHMT-3, no. 3,
pages 424-430, New York, USA A.J. MASESSA et al.:
"Design and development of a 68-lead nonhermetic
leaded chip carrier"

(73) Titulaire: THOMSON-CSF, 173, Boulevard Haussmann,
F-75379 Paris Cedex 08 (FR)

(72) Inventeur: Lacruche, Bernard, THOMSON-CSF
SCPI 173, bld Haussmann, F-75379 Paris Cedex 08 (FR)
Inventeur: Fromont, Thierry, THOMSON-CSF
SCPI 173, bld Haussmann, F-75379 Paris Cedex 08 (FR)

(74) Mandataire: Taboureau, James et al, THOMSON-CSF
SCPI 173, Bld Haussmann, F-75379 Paris Cedex 08 (FR)

## Description

La présente invention concerne un support pour cartes de circuit électronique, comportant une pluralité de circuits intégrés à haute densité, encapsulés dans boîtiers à connexions d'accès périmétriques: afin d'évacuer les calories dégagées par les circuits au cours de leur fonctionnement, chaque boîtier de circuit intégré est en liaison thermique directe avec un drain thermique, solidaire d'un radiateur, ce drain thermique traversant le circuit d'interconnexion entre les circuits intégrés, grâce à une ouverture dans le circuit d'interconnexion à l'aplomb de chaque boîtier de circuit intégré.

A l'augmentation de la densité d'intégration dans les circuit intégrés et à l'augmentation de la complexité des circuits électroniques qu'elle a permis sont liés plusieurs problèmes de nature différente.

En raison de l'augmentation de la densite d'intégration, les circuits intégrés les plus récents, même réalisés dans les technologies les plus performantes, dissipent chacun une quantité d'énergie non négligeable, de l'ordre de 1 à 5 Watts par exemple chacun pour des circuits intégrés logiques. Lorsqu'une carte de circuit électronique comporte de l'ordre d'une centaine de boîtiers de circuit intégrés, elle dissipe donc de l'ordre de 100 à 500 Watts. Il faut donc monter chaque boîtier sur un drain thermique, quel qu'il soit.

Mais à l'augmentation de densité d'intégration est liée, très généralement, une augmentation du nombre des connexions d'accès, et comme simultanément les boîtiers de type DIL, à deux rangées parallèles de connexions latérales, sont jugés trop importants en surface-jusqu'à 5 cm de longueur de boîtier pour une pastille de circuit intégré de 5 mm environ de côté-les circuits intégrés à haute intégration sont actuellement encapsulés dans des boîtiers de type »chip-carrier«, dont les connexions de sorties sont réparties sur tout le périmètre. Cece empêche donc de faire reposer le boîtier, comme cela se pratique avec les boîtiers DIL à deux rangées de connexions parallèles, sur un barreau métallique qui sert de drain thermique.

Par ailleurs, l'augmentation de complexité des circuits électroniques, a amené à regrouper sur une même plaque ou sur un support un nombre important de composants. La flexibilité d'une plaque de dimension suffisante pour supporter, à titre d'exemple, de l'ordre de 20 à 100 circuits intégrés plus des composants discrets, entraîne alors le risque d'arrachage par cisaillement des soudures sur les connexions de sorties, au niveau du réseau d'interconnexion. Ce phénomène de cisaillement est en outre favorisé par la différence des coefficients de dilatation entre les boîtiers de circuits intégrés et la nature du matériau qui constitue la plaque support. Disposer d'un support de grande dimension, rigide, en lui donnant de l'épaisseur n'est pas une solution industrielle. Par contre, il est connu de réaliser des plaques supports de grande dimension qui allient la rigidité d'une plaque métallique et un circuit d'interconnexion, collés ensemble : la plaque métallique, en acier ou en aluminium par exemple apporte en plus de sa rigidité une fonction de drain thermique.

Ainsi, selon l'art connu, dans le cas de supports de grande dimension comportant un nombre important de circuit intégrés, les microboîtiers sont fixés sur un substrat d'interconnexion qui facilite les liaison électriques mais qui rompt la liaison thermique, étant isolant électrique et également isolant thermique ou au moins mauvais conducteur thermique. Quel que soit le procédé adopté pour évacuer les calories il demeure toujours une impédance thermique important entre la source de chaleur et le moyen de refroidissement, en raison de l'interposition d'un substrat d'interconnexion.

Lorsqu'il s'agit de pastilles semiconductrices qui dissipent de la chaleur, tels que par exemple les transistors de puissance ou les circuits intégrés, on connait deux procédés pour évacuer la chaleur par le substrat de la pastille. Le procédé le plus courant, appliqué notamment aux transistors de puissance, consiste à interposer entre la pastille et son embase métallique, qui sert de radiateur, une plaquette d'oxyde de béryllium, qui est un bon conducteur thermique. L'embase métallique peut être insérée dans un circuit hybride ou sur un substrat diélectrique: elle sert de puits thermique. Une telle solution est décrite par exemple dans le document US-A-3753-056. Mais si le circuit électrique ou les polarités s'y prêtent, une autre solution consiste à fixer la pastille semiconductrice directement sur un socle métallique. Le document US-A-3936-866 décrit un montage dans lequel un socle métallique est fixé sur un substrat isolant électrique d'alumine ou d'oxyde de béryllium: cette solution présente l'inconvénient de rétablir une impédance thermique entre la pastille et le radiateur. L'article de Y. Mitsui et al., paru dans I. EEE, vol. MTT-29, d'avrill 1981, pages 304 à 308, décrit un montage dans lequel une pastille de transistor hyperfréquence est soudée »à l'envers«, selon la technologie connue sous le nom »flip-chip« en anglais. Dans ce montage, l'une des métallisations des contacts soit de source, soit de drain, est directement soudée sur un socle métallique, qui fait saillie à travers une couche de diélectrique sur laquelle sont soudées les deux autres métallisations. Ce socle métallique sert de puits thermique, vers une embase métallique qui sert de radiateur: la source de chaleur est en contact direct avec un radiateur, mais il ne s'agit là que d'une pastille nue, sans enrobage plastique ou céramique.

Selon l'invention, la source de chaleur, c'est-à-dire le boîtier d'encapsulation de circuit intégré, est en liaison directe avec le drain thermique et le radiateur de dissipation, et l'impédance thermique est réduite à celle d'une mince pellicule de colle ou de soudure entre boîtier et drain thermique, tandis que le substrat d'interconnexion électrique est adapté à ce montage thermique: le substrat d'interconnexion, monocouche ou multicouches, comporte une ouverture à l'emplacement du drain thermique de chaque boîtier, les dimensions de cette ouverture étant telles que le boîtier repose dans sa partie centrale sur le drain thermique et est soudé sur son pourtour, par ses connexions d'accès, sur le réseau d'interconnexion.

De façon plus précise, l'invention concerne un support de montage d'un microboîtier de circuit intégré, à connexions de sortie périmétriques repliées sous corps du boîtier, sur un circuit électronique se composant d'une part d'un substrat isolant porteur de bandes métalliques d'interconnexion sur lesquelles le microboîtier est fixé par soudure de ses connexions de sortie, d'autre part d'un élément métallique assurant la double fonction de renfort mécanique du substrat d'interconnexion et de dissipateur de la chaleur dégagée par le circuit intégré au cours de son fonctionnement, ce support étant caractérisé en ce que l'élément métallique dissipateur comporte un drain thermique constitué par un bossage s'étendant à travers une ouverture réalisée dans le substrat isolant d'interconnexions rapporté et fixé de façon souple sur l'élément dissipateur et dont les dimensions latérales correspondent à celles du drain thermique, la hauteur de ce bossage étant telle qu'elle est de l'ordre de l'épaisseur dudit substrat isolant d'interconnexions et ses dimensions latérales inférieures aux dimensions latérales du microboîtier de manière à ce qu'il puisse assurer un contact mécanique et thermique avec la face inférieure du microboîtier sans toucher et courtcircuiter les connexions de sortie périmétriques du microboîtier.

L'invention sera mieux comprise par la description d'exemples de réalisation, cette description s'appuyant sur les figures annexées qui représentent:

figure 1 montage d'un boîtier de circuit intégré à connexion périmétrique sur une carte, selon l'art connu;

figure 2 synthèse d'exemples de dispositifs de refroidissement d'un boîtier de circuit intégré, selon l'art connu;

figure 3 l'invention selon un premier exemple d'application;

figure 4 l'invention selon un second exemple d'application;

figure 5 schéma montrant l'adaptation du circuit d'interconnexion sur le radiateur thermique comportant les drains thermiques;

figure 6 vue éclatée d'un élément de support selon l'invention permettant de voir le montage d'un circuit intégré sur le substrat d'interconnexion et sur le drain thermique.

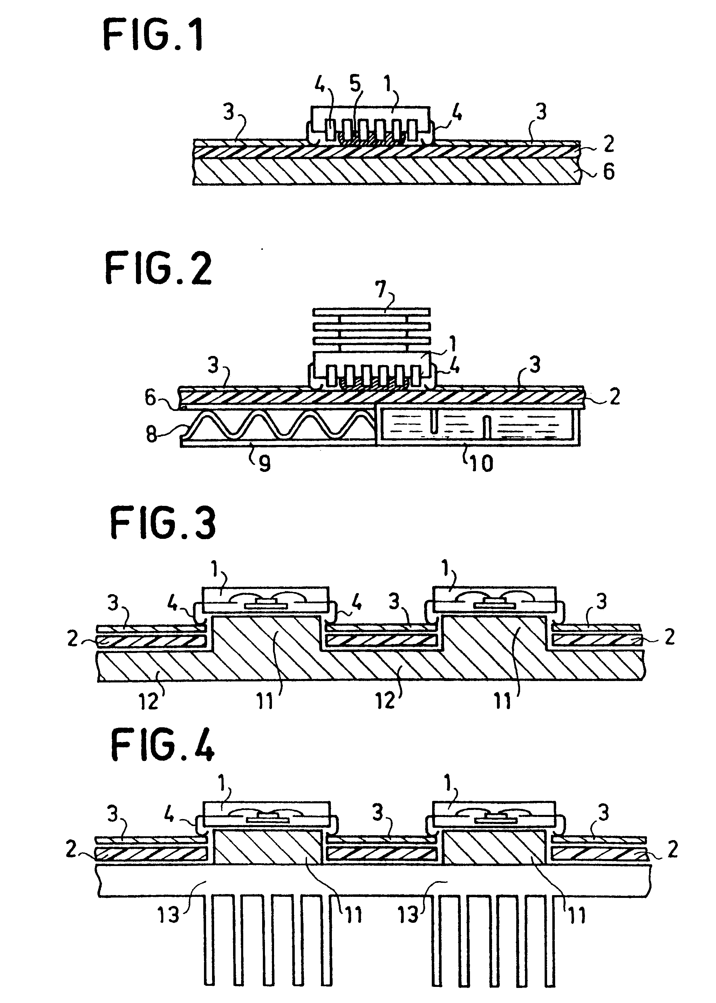

La figure 1 représente le montage selon l'art connu d'un circuit intégré encapsulé dans un boîtier à connexions périmétriques sur un support de carte de circuit électronique.

Le boîtier de circuit intégré 1 est fixé sur un substrat d'interconnexion 2 qui est très généralement constitué soit d'une plaque de céramique, si les dimensions le permettent, soit d'un complexe de type tissu de verre/époxy ou polyimide, ou plus généralement polymère armé. Ce substrat 2 supporte le réseau d'interconnexion 3 constitué par des bandes métalliques, généralement en cuivre. Le boîtier 1 est soudé sur les bandes métalliques du réseau d'interconnexions 3 par l'intermédaire de ses connexions d'accès 4.

Entre le boîtier 1 et le substrat d'interconnexion 2 existe un certain espace qui est rempli par un joint thermique, par exemple une colle chargée pour être conductrice de la chaleur.

L'ensemble est supporté si nécessaire par un élément métallique ou par un radiateur 6.

Il est important de préciser que dans ce domaine des circuit intégrés à haute densité d'intégration la tendance actuelle est de les monter dans des boîtiers à connexion périmétriques dont les connexions extérieurs sont repliées sous le boîtier de façon à présenter une certaine élasticité. En effet, entre l'élément radiateur 6 métallique, le substrat d'interconnexion 2 en matière minérale céramique ou en matière organique, et le corps du boîtier 1 soit céramique soit encapsulation plastique de type silicone, les coefficients de dilatation sont très nettement différents, de l'ordre de 1 à 3. Par conséquent, au cours du fonctionnement du dispositif, ou puisqu'il a été précisé qu'il s'agit de cartes comportant un grand nombre de circuits intégrés, la dilatation de l'élément thermique 6, celle du substrat d'interconnexion 2, et celle du corps du microboîtier 1 sont différentes et avec la technique des connexions de sorties qui sont sérigraphiées sur un corps de boîtier 1 en céramique par exemple, il n'y a aucune souplesse dans les connexions de sortie et les différence de dilatation aboutissent à un arrachement ou plus précisément à un cisaillement de la soudure des connexions de sorties sur le réseau d'interconnexion. C'est pourquoi la présente invention concerne les microboîtiers à connexions périmétriques dont les connexions d'accès sont repliées sous le corps du microboîtier de façon à présenter une certaine souplesse qui amortit les différences de dilatation.

Dans ce montage selon l'art connu, entre la source de chaleur qui est le corps du microboîtier 1 et le drain thermique 6 se présente une impédance thermique élevée constituée d'abord par la goutte de colle, ou de soudure si le corps du microboîtier comporte une partie métallisée, et ensuite par le substrat d'interconnexion qui, étant un isolant électrique, rdz également sinon un isolant du moins un mauvais conducteur thermique.

La figure 2 représente une synthèse de quelques procédés connus pour éliminer la chaleur dégagée par la pastille de circuit intégré dans un microboîtier.

Comme sur la figure précédente, cette figure 2 représente un élément de circuit complexe comportant un microboîtier de circuit intégré 1 fixé sur un substrat d'interconnexion 2 par l'intermédiaire de soudures prises sur les bandes d'interconnexion 3 par les connexions de sorties 4. Il est connu de fixer sur la partie supérieure du microboîtier un radiateur tel que le radiateur à ailettes 7 représenté ici et de forcer de l'air pour évacuer les calories dégagées par le dessus du boîtier.

Du côté du support, c'est-à-dire de la face inférieure du microboîtier, il est également connu de mettre à profit la présence d'une plaque métallique 6 qui sert à renforcer le substrat d'interconnexion 2 et de lui adjoindre un système tel qu'une tôle ondulée 8 et une seconde plaque de fermeture 9, et de forcer une circulation d'air à l'intérieur de ce système.

Enfin, sur la partie droite de cette figure est représenté un troisième système connu qui consiste à adjoindre un boîtier 10 sous le substrat d'interconnexion et d'y faire circuler de l'eau ou un fluide.

D'autres systèmes sont également connus, mais tous les systèmes connus jusqu'à présent maintiennent toujours une impédance thermique relativement élevée entre la source de chaleur qui est le microboîtier 1 et l'élément radiateur: cette impédance thermique étant constituée par la goute de colle ou de soudure sous le boîtier et par le support isolant qui constitue le substrat d'interconnexion 2.

De plus, selon certaines normes, et pour certains matériels tels que les matériels militaires ou spatiaux, il n'est pas permis de faire circuler un fluide tel que de l'air ou de l'eau pour refroidir: ceci est inconcevable dans un matériel tel qu'un satellite par exemple.

La figure 3 représente une première forme de réalisation du support de circuit électronique selon l'invention. Cette figure représente une coupe, au niveau du milieu de deux boîtiers, et les dimensions verticales ont été dilatées de façon à plus facilement faire apparaître la structure de ce support.

Selon l'invention, un microboîtier 1 de circuit intégré repose directement sur un drain thermique 11 constitué par une pièce métallique sur laquelle il est fixé, cette pièce métallique ayant une forme extérieure de dimensions telles qu'elle peut passer sous le microboîtier sans toucher et sans court-circuiter les connexions externes 4 du microboîtier. L'épaisseur de ce drain métallique 11 est telle qu'elle permet d'assurer un contact mécanique, c'est-à-dire également un contact thermique, avec la face postérieure du microboîtier 1 lorsque celui-ci est fixé par l'intermédiare de ses connexions estérieures 4 sur le substrat d'interconnexion 2: celui-ci comporte des ouvertures, c'est-à-dire des perforations qui correspondent, au jeu de montage près, aux dimensions extérieures des drains thermiques 11, ou encore aux dimensions intérieures du système de connexions externes du microboîtier 1. Chaque drain thermique a donc épaisseur de l'ordre de celle du substrat d'interconnexion: ceci remplace avantageusement l'impédance thermique qui était constituée selon l'art connu par une épaisseur de colle ou de soudure 5 et une épaisseur de substrat isolant 2. En outre, chaque drain thermique 11 est solidaire et thermiquement réuni à un système d'absorption ou d'évacuation des calories représenté sur la figure 3 par une plaque métallique 12.

L'usinage des drains thermiques 11 peut être réalisé de plusieurs façons: par usinage direct dans une plaque métallique plus épaisse, par usinage chimique après masquage de la partie supérieure de chaque drain thermique 11 afin d'éviter son attaque chimique, ou encore par repoussage de métal; dans ce cas la face inférieure de la plaque 12 n'est plus plane mais cela ne présente pas d'inconvénient.

La fixation d'un microboîtier 1 de circuit intégré sur son drain thermique 11 peut se faire de plusieurs façons. S'il s'agit d'un microboîtier moulé en matière plastique, une mince pellicule de colle assure un contact thermique, nettement supérieur à la goutte de colle selon l'art antérieur, car cette goutte de colle a une épaisseur correspondant à la longueur des pattes de fixation 4, tandis que, selon l'invention, la pellicule de colle peut être limitée à quelques microns d'épaisseur. S'il s'agit d'un microboîtier céramique, sa face postérieure peut être métallisée, ou d'un microboîtier plastique à drain métallique, le microboîtier est fixé par soudure, par exemple par le procédé de refusion en phase vapeur sur le drain thermique 11.

Le circuit complet d'interconnexions, c'est-à-dire la pièce comportant un substrat isolant 2 et le réseau de bandes métalliques conductrices 3, est réalisé séparément. Dans un premier temps, il est perforé par poinçonnage, aux endroits correspondants aux drains thermiques 11 des différents circuits intégrés du circuit électronique, puis dans un deuxième temps, il est rapporté sur le radiateur, ou support de circuit 12, et est fixé de façon souple. La souplesse des liaisons entre les connexions externes 4 des circuits intégrés et le réseau d'interconnexions est une chose importante puisqu'il a été dit que dans ce cas de circuit électronique complexe, les différences de dilatation entre les boîtiers, le réseau d'interconnexions, le substrat arrivent à cisailler les soudures entre les connexions 4 et les bandes conductrices 3. On peut donc concevoir, si le nombre de circuits intégrés fixé sur des drains thermiques 11 est suffisant, que le réseau d'interconnexions soit très légèrement fixé sur la plaque d'embase 12, et que ce soit en fait les circuits intégrés et leurs connexions externes 4 qui maintiennent en place le réseau d'interconnexions.

La figure 4 représente une autre forme de réalisation du support de circuit électronique selon l'invention. La partie circuits intégrés et circuits d'interconnexions est identique à celle qui est représentée en figure 3. Mais chaque drain thermique 11 n'est plus usiné dans une plaque 12, mais rapporté sur un support qui sert de radiateur 13. Ceci peut, dans certains cas, faciliter des réalisations relatives à des circuits électroniques dissipant beaucoup. Ainsi, au lieu de partir d'un support métallique constitué par une plaque dans laquelle il faut usiner des drains, on part d'un circuit d'interconnexions et de drains qui se présentent sous forme de pastilles et on rapporte le tout sur des éléments adaptés à la puissance à dissiper, ces éléments pouvant être des éléments munis d'ailettes comme il est représenté sur la figure 4 ou des éléments comportant, si les normes de fabrication le permettent, une circulation de fluide comme cela a été représenté en figure 2.

L'important dans ce cas est d'assurer un bon contact thermique entre le drain 11 et le support métallique 13, ce contact étant assuré de la façon la plus courante par soudure ou brasure des drains thermiques 11 sur la plaque support 13.

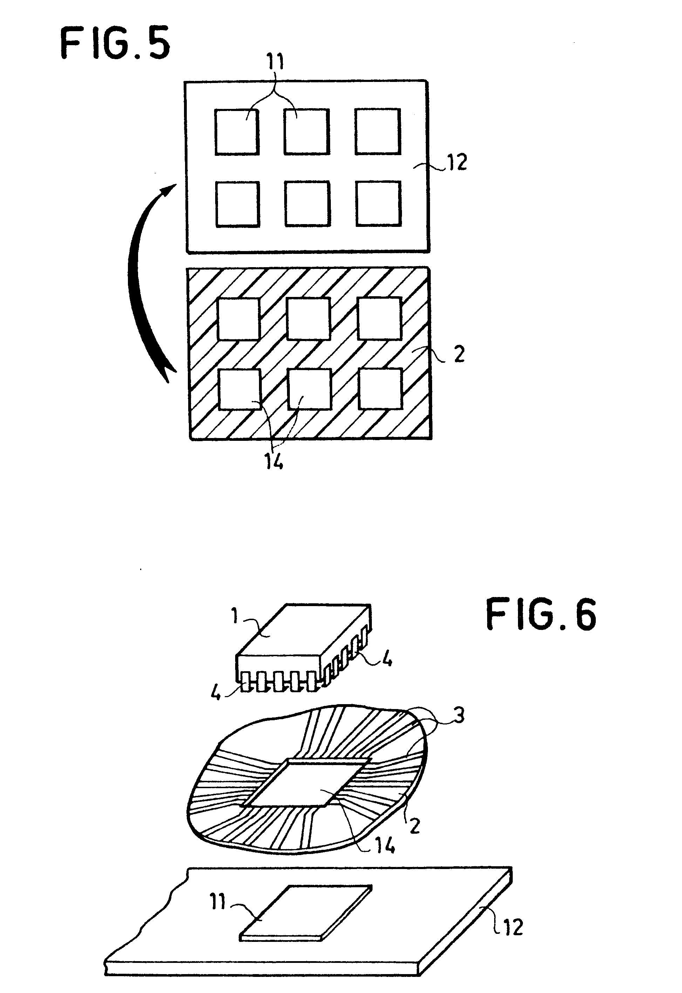

La figure 5 représente une vue en plan des deux pièces principales constitutives d'un circuit électronique complexe, c'est-à-dire le substrat d'interconnexion 2 et le radiateur thermique 12.

Sur la figure 5, chacune de ces deux pièces est représentée séparément et un nombre de circuit intégrés limité à six a été choisi, bien que dans la réalité une telle plaque-support comporte, comme il a été dit, de l'ordre de 20 à 100 circuits intégrés.

Sur la partie supérieure de la figure 5 apparaît la plaque métallique qui sert de radiateur 12 et sur cette plaque sont usinés ou rapportés des drains thermiques 11. Sur la partie inférieure de la figure 5, apparaît le substrat d'interconnexion 2 dans lequel sont pratiquées des ouvertures 14, le nombre, les dimensions et la position de chaque ouverture 14 correspondant au nombre, aux dimensions et à la position des drains 11, et aux circuits intégrés qui seront fixés sur chaque drain.

On voit par conséquent que le réseau d'interconnexions, ou plus exactement le support de polyimide out de tissu de verre époxy, qui soutient le réseau d'interconnexion apparaît comme étant le négatif du support thermique du circuit: à drain thermique 11 en relief correspond une ouverture 14.

La figure 6 représente une vue partielle d'un circuit complexe selon l'invention, cette vue étant limitée à un seul microboîtier et à son système de jonction thermique avec le radiateur. D'une part, est constitué un dispositif d'absorption et d'évacuation des calories contitué par au moins une plaque métallique 12, sur laquelle sont rapportés ou dans laquelle sont usinés des drains thermiques 11, en relief.

D'autre part, est usiné un dispositif d'interconnexion 2 comportant un substrat isolant et des bandes métalliques 3, aboutissant é la périphérie de chaque ouverture 14 dans le substrat. Le substrat d'interconnexion étant posé et éventuellement fixé par un adhésif souple sur un support mécanique 12, chaque circuit intégré est alors amené en position et ses connexions externes 4 sont soudées sur les bandes 3 du réseau d'interconnexions par refusion en phase vapeur ou par soudure à l'étain.

**Revendications**

1. Support de montage d'un microboîtier de circuit intégré, à connexions de sortie périmétriques repliées sous le corps du boîtier, sur un circuit électronique se composant d'une part d'un substrat isolant porteur de bandes métalliques d'interconnexion sur lesquelles le microboîtier est fixé par soudure de ses connexions de sortie, d'autre part d'un élément métallique assurant la double fonction de renfort mécanique du substrat d'interconnexion et de dissipateur le la chaleur dégagée par le circuit intégré au cours de son fonctionnement, ce support étant caractérisé en ce que l'élément métallique (12) dissipateur comporte un drain thermique (11) constitué par un bossage s'étendant à travers une ouverture (14) réalisée dans le substrat isolant d'interconnexions (2) rapporté et fixide façon souple sur l'élément dissipateur et dont les dimensions latérales correspondent à celles du drain thermique, la hauteur de ce bossage étant telle qu'elle est de l'ordre de l'épaisseur dudit substrat isolant d'interconnexions (2) et ses dimensions latérales inférieures aux dimensions latérales du microboîtier (1) de manière à ce qu'il puisse assurer un contact mécanique et thermique avec la face inférieure du microboîtier sans toucher et courtcircuiter les connexions de sortie périmétriques (4) du microboîtier.

2. Support de montage selon la revendication 1, caractérisé en ce que le drain thermique (11) est usiné dans l'élément dissipateur (12).

3. Support de montage selon la revendication 1, caractérisé en ce que le drain thermique (11) est rapporté sur l'élément dissipateur (12) par soudure ou brasage.

4. Assemblage d'un microboîtier sur un support de montage selon la revendication 1, caractérisé en ce que le boîtier de circuit intégré (1) est directement soudé sur le drain thermique (11).

5. Assemblage d'un microboîtier sur un support de montage selon la revendication 1, caractérisé en ce que le boîtier de circuit intégré (1) est directement collé sur le drain thermique (11) par une fine pellicule de colle conductrice thermique.

6. Support de montage selon la revendication 1, caractérisé en ce que la fixation souple du substrat d'interconnexion (2) sur l'élément dissipateur (12) est telle que le substrat d'interconnexion (2)

— soit fixé par un adhésif souple sur l'élément dissipateur (12),
— soit posé sur l'élément dissipateur (12) et maintenu en place par les connexions de sortie (4) du microboîtier (1) lui-même fixé sur le drain thermique (11),
— la souplesse de la fixation substrat/dissipateur (2—12) absorbant, au niveau des connexions de sortie (4), les différence de dilatation en fonctionnement entre le substrat d'interconnexion (2) et l'élément dissipateur (12).

**Patentansprüche**

1. Montageträger für ein Mikrogehäuse eines integrierten Schaltkreises mit randseitigen Ausgangsanschlüssen, die um den Gehäusekörper nach unten auf einen elektronischen Schaltkreis umgebogen sind, wobei dieser Schaltkreis einerseits ein isolierendes Substrat, das metallische Verbindungsstreifen trägt, auf die das Mikrogehäuse durch Anlöten seiner Ausgangsanschlüsse aufgebracht ist, und andererseits ein Metallelement aufweist, das die zweifache Rolle der mechanischen Versteifung des Verbindungssubstrats und der Abfuhr der vom integrierten Schaltkreis während seines Betriebs erzeugten Wärme übernimmt, dadurch gekennzeichnet, daß das metallische Abfuhrelement (12) einen thermischen Drain (11) enthält, der von einem sich durch eine im isolierenden Verbindungssubstrat (2) ausgebildete Öffnung (14) erstreckenden Vorsprung gebildet wird und auf dem Abfuhrelement aufgebracht und nachgiebig befestigt ist und dessen seitliche Abmessungen denen des thermischen Drains entsprechen, wobei die Höhe des Vorsprungs so gewählt ist, daß sie etwa der Dicke des isolierenden Verbindungssubstrats (2) entspricht, während seine seitlichen Abmessungen geringer als die seitlichen Abmessungen des Mikrogehäuses (1) sind, so daß der Vorsprung einen mechanischen und thermischen Kontakt mit der Unterseite des Mikrogehäuses herstellt, ohne die randseitigen Ausgangsanschlüsse (4) des Mikrogehäuses zu berühren und kurzzuschließen.

2. Montageträger nach Anspruch 1, dadurch gekennzeichnet, daß der thermische Drain (11) durch formende Bearbeitung des Abfuhrelements (12) gebildet wird.

3. Montageträger nach Anspruch 1, dadurch gekennzeichnet, daß der thermische Drain (11) auf das Abfuhrelement (12) durch Schweißen oder Löten aufgebracht ist.

4. Anordnung eines Mikrogehäuses auf einem Montageträger nach Anspruch 1, dadurch gekennzeichnet, daß das Gehäuse mit dem integrierten Schaltkreis (1) unmittelbar auf den thermischen Drain (11) aufgeschweißt ist.

5. Anordnung eines Mikrogehäuses auf einem Montageträger nach Anspruch 1, dadurch gekennzeichnet, daß das Gehäuse mit dem integrierten Schaltkreis (1) unmittelbar auf den thermischen Drain (11) mithilfe einer dünnen Schicht eines thermisch leitenden Klebers aufgeklebt ist.

6. Montageträger nach Anspruch 1, dadurch gekennzeichnet, daß die nachgiebige Befestigung des Verbindungssubstrats (2) auf dem Abfuhrelement (12) so ausgeführt ist, daß das Verbindungssubstrat (2)

— mithilfe eines nachgiebigen Klebers auf dem Abfuhrelement (12) befestigt ist,

— auf das Abfuhrelement (12) aufgelegt und durch die Ausgangsanschlüsse (4) des Mikrogehäuses (1), das seinerseits auf dem thermischen Drain (11) befestigt ist, festgehalten wird,

— wobei die Nachgiebigkeit der Befestigung zwischen dem Substrat und dem Abfuhrelement (2—12) in Höhe der Ausgangsanschlüsse (4) die unterschiedlichen Ausdehnungen zwischen dem Verbindungssubstrat (2) und dem Abfuhrelement (12) im Betrieb absorbiert.

**Claims**

1. A mounting support for an integrated circuit housing, with output connections around the housing perimeter bent back under the body of the housing, on an electronic circuit which is constituted on the one hand of an insulating substrate bearing metallic interconnection strips on which the housing is fixed through its output connections welded thereto, and on the other hand of a metal element which ensures the double role of a mechanical stiffener for the interconnection support and of a dissipator of heat released from the integrated circuit during operation, this support being characterized in that the metallic dissipator element (12) comprises a thermal drain (11) constituted of a projection which extends through an opening (14) in the insulating interconnections support (2) and which is applied and resiliently fixed to the dissipator element, the lateral dimensions of this projection corresponding to those of the thermal drain, the height of this projection being approximately equal to the thickness of said insulating interconnections substrate (2) and its lateral dimensions corresponding to the lateral dimensions of the housing (1) in such a way that a mechanical and thermal contact with the lower face of the housing is ensured without touching and shortcircuiting the output connections (4) around the perimeter of the housing.

2. A mounting support according to claim 1, characterized in that the termal drain (11) is integral with the dissipator element (12).

3. A mounting support according to claim 1, characterized in that the thermal drain (11) is applied to the dissipator element (12) by welding or soldering.

4. An assembly of a micro-housing on a mounting support according to claim 1, characterized in that the integrated circuit housing (1) is directly welded to the thermal drain (11).

5. An assembly of a micro-housing on a mounting support according to claim 1, characterized in that the integrated circuit housing (1) is directly glued onto the thermal drain (11) through a fine layer of thermally conducting adhesive material.

6. A mounting support according to claim 1, characterized in that the resilient fixation of the interconnection substrate (2) on the dissipator element (12) is made in such a way that the interconnection substrate (2)

— ist fixed to the dissipator element (12) through a resilient adhesive material,
— is laid down on the dissipator element (12) and immobilized by the output connections (4) ot the housing (1), which itself is fixed to the thermal drain (11),
— the flexibility of the fixation between the substrate (2) and the dissipator (12) absorbing in the output connections area (4) the differences of expansion between the interconnection substrate (2) and the dissipator element (12) during operation.

# FIG.1

# FIG.2

# FIG.3

# FIG.4

# FIG.5

# FIG.6